# EUROPEAN PATENT APPLICATION

(11) **EP 4 160 300 A1**
(43) Date of publication of application: **05.04.2023**
(21) Application number: 21200077.2
(22) Date of filing: 30.09.2021
(51) Int. Cl.: G02F 1/01, G02F 1/09

(54) **FREQUENCY-DEPENDENT MICROWAVE FILTER, ARRANGEMENT COMPRISING THE SAME, AND METHOD OF FREQUENCY-DEPENDENT MICROWAVE FILTERING**

(71) Applicant: Rohde & Schwarz GmbH & Co. KG, 81671 München (DE)
(72) Inventor: Ruster, Dr. Thomas, 81543 München (DE)
(74) Representative: Rupp, Christian

(57) **Abstract**

Disclosed is a frequency-dependent microwave filter (1). The filter (1) comprises an enclosure (11) comprising a filter medium including at least one constituent of: atoms, molecules, ions, and point defects in an optically pumpable solid. The at least one constituent is excitable to an initial energy state. The filter (1) further comprises a field generator (12) configured to generate an inhomogeneous electric and/or magnetic field (12A) within the enclosure (11). The filter (1) further comprises means (13) for feedthrough of a microwave signal through the enclosure (11) and an optical pump (14) configured to periodically excite the at least one constituent of the filter medium to the initial energy state in alternation with the feedthrough of the microwave signal through the enclosure (11). Thereby, intensity-dependent filtering is achieved.

## Description

### Technical Field

The present disclosure relates to power limiting in microwave communication, and in particular to devices and methods of frequency-dependent microwave filtering.

### Background Art

In microwave communication, overloading of receiver components such as amplifiers, analog-to-digital converters (ADCs) is typically avoided by limiting a power of strong frequency components of the received signal upstream of said receiver components.

For example, power limiters or filter banks may be deployed to this end.

Power limiters usually attenuate all frequency components, which makes it hard to analyse weak signals in the presence of strong undesired signals, such as jammers.

Filter banks can attenuate certain frequency ranges but have to be programmed in accordance with previously measured data.

### Summary

In view of the above-mentioned drawbacks and limitations, the present disclosure aims to improve the power limiting capability of the background art. An objective is to provide devices and methods offering frequency-dependent microwave filtering, in particular for power limiting purposes.

The objective is achieved by the embodiments as defined by the appended independent claims. Preferred embodiments are set forth in the dependent claims and in the following description and drawings.

A first aspect of the present disclosure relates to a frequency-dependent microwave filter. The filter comprises an enclosure comprising a filter medium including at least one constituent of: atoms, molecules, ions, and point defects in an optically pumpable solid. The at least one constituent is excitable to an initial energy state. The filter further comprises a field generator configured to generate an inhomogeneous electric and/or magnetic field within the enclosure. The filter further comprises means for feedthrough of a microwave signal through the enclosure. The filter further comprises an optical pump configured to periodically excite the at least one constituent of the filter medium to the initial energy state in alternation with the feedthrough of the microwave signal through the enclosure.

The enclosure may comprise at least one of: a gas cell, and a diamond.

The gas may comprise at least one chemical element.

The at least one chemical element may be from a first main group.

The at least one chemical element may comprise rubidium.

The at least one chemical element may further comprise at least one of: nitrogen, neon and radon.

The filter may further comprise an optical cavity comprising the enclosure.

The means for feedthrough may comprise a waveguide.

The waveguide may comprise a wire.

The filter may further comprise a power splitter or power switch configured to split up the microwave signal into a plurality of partial microwave signals on respective waveguides configured to guide the plurality of partial microwave signals through the filter medium at respective lateral positions relative to a propagation direction of the plurality of partial microwave signals.

The filter may further comprise a number of phase shifters interposed in the respective waveguides and configured to shift a relative phase of the plurality of partial microwave signals in accordance with a Rabi frequency of the periodic excitation of the comprised filter medium.

The field generator may comprise a permanent magnet or electromagnet.

The optical pump may comprise a coherent light source being resonant to at least one energy transition in the at least one constituent of the filter medium.

The optical pump may be configured to excite the filter medium in a continuous wave, CW, mode or in a pulsed mode.

The optical pump may be configured to excite the filter medium from a lateral direction perpendicular to the propagation direction of the microwave signal.

A second aspect of the present disclosure relates to an arrangement, comprising a microwave amplifier; and a filter of the first aspect or any of its implementations arranged upstream of the microwave amplifier.

A third aspect of the present disclosure relates to a method of frequency-dependent microwave filtering. The method comprises generating an inhomogeneous electric and/or magnetic field within an enclosure. The enclosure comprises a filter medium including at least one constituent of: atoms, molecules, ions, and point defects in an optically pumpable solid. The at least one constituent is excitable to an initial energy state. The method further comprises periodically exciting the at least one constituent of the filter medium to the initial energy state in alternation with a feedthrough of the microwave signal through the enclosure.

A respective absorption rate of frequency components of the microwave signal increases with a respective energy of its frequency components.

The method may be performed by a filter of the first aspect or any of its implementations.

### Advantageous Effects

The underlying idea is to use a vapor cell or a solid with optically active point defects, such as an NV diamond (or in other words, any ensemble of particles with frequency-tunable resonance) in an inhomogeneous static - in particular magnetic - field to absorb strong frequency components of an RF / microwave signal upon traversal of the vapor cell or solid.

Presence of a laser beam of adequate frequency is used for optical pumping / initialization of the respective N-level quantum system (N ≥ 2), such as the gas particles of the vapor cell or the point defects of the solid, to a ground state (i.e., initial energy state).

A nitrogen-vacancy center (N-V center or NV center) may refer to a particular point defect in diamond lattice. Being a quantum system having ground and excited states/levels, electron transitions between these states produce absorption and luminescence. The energy difference between the *mₛ* = 0 and *mₛ* = ±1 states (where *mₛ* indicates a spin quantum number) corresponds to the microwave regime, so that a population can be transferred between said states using a microwave field.

An initial energy state may refer to an excited energy state/level of particles such as atoms, ions or molecules wherein an outermost electron is substantially farther away from the nucleus as in a normal state. For example, the initial energy state may comprise a Rydberg state. Particles in a Rydberg state may be seen as quantum systems having "ground" (i.e. Rydberg) and excited energy states/levels. An advantage of Rydberg states is that they have multiple energy transitions in the GHz-THz range so that filtering is possible in a wide frequency range. Owing to their extraordinarily large dimension with respect to regular particles, they are particularly sensitive to excitation by electric and/or magnetic fields.

Since no optical readout of the laser beam is necessary, it is possible to add an optical cavity to enhance the optical power within the vapor cell.

Presence of an inhomogeneous magnetic field formed by a permanent magnet or electromagnet, such as a coil of wire, is used to cause Zeeman splitting, which ensures availability of gas particles or point defects in a ground state for each frequency in a desired frequency range, which may be included in a microwave frequency range ranging between 300 MHz and 300 GHz, respectively. For particles in the Rydberg state, filtering may be possible up to the THz regime. For ground-state Rubidium atoms in an inhomogeneous magnetic field, filtering may be possible up to ∼60 GHz.

Zeeman splitting may refer to splitting of a spectral line into several components in the presence of a static magnetic field. Stark splitting, the electric-field analogue of Zeeman splitting, may refer to splitting of a spectral line into several components in the presence of a static electric field.

The microwave signal is carried by a wave guide, such as a wire, traversing the vapor cell or solid. The electromagnetic field of the microwave signal may interact with the gas particles of the vapor cell or the point defects of the solid. More specifically, a respective absorption rate of frequency components of the microwave signal increases with a respective energy of the frequency components. As such, for a given duration of the RF / microwave radiation, high-energy frequency components achieve a more exhaustive population inversion of the gas particles or point defects from the ground state to the excited state than low-energy frequency components, corresponding to intensity-dependent filtering.

A split of the RF / microwave signal onto multiple waveguides with different positions within the vapor cell or solid and/or different intensities and/or different phases (implementing composite pulse schemes known from nuclear magnetic resonance (NMR) or dynamical decoupling (DD) schemes) may ensure a continuous operation of the filter in at least one portion of the filter at any time, while the gas particles or point defects in other portions of the filter revert to a ground state in accordance with a Rabi cycle.

A Rabi cycle may refer to a cyclic behavior of a two-level quantum system in the presence of an oscillatory driving field. A two-level system is one that has two possible energy levels, a ground state with lower energy and an excited state with higher energy. When the two-level system is illuminated by a coherent beam of photons, such as a laser beam, it will cyclically transition from the ground state to the excited state by absorption of photons and re-emit them by stimulated emission. One such cycle is called a Rabi cycle and the inverse of its duration the Rabi frequency of the photon beam.

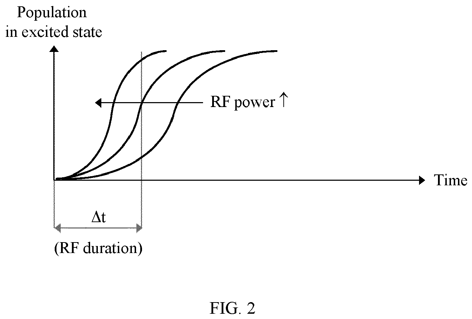

Intensity-dependent filtering is achieved by choosing the laser and microwave interaction times accordingly (see FIG. 2), which may be used for power limiting in microwave receivers, for example.Advantageously, the technical effects and advantages described above in relation with the filter of the first aspect equally apply to the arrangement of the second aspect comprising the filter as well as to the method of the third aspect having corresponding features.

### Brief Description of Drawings

The above-described aspects and implementations will now be explained with reference to the accompanying drawings, in which the same or similar reference numerals designate the same or similar elements.

The features of these aspects and implementations may be combined with each other unless specifically stated otherwise.

The drawings are to be regarded as being schematic representations, and elements illustrated in the drawings are not necessarily shown to scale. Rather, the various elements are represented such that their function and general purpose become apparent to those skilled in the art.
- FIG. 1: illustrates a frequency-dependent microwave filter in accordance with the present disclosure;
- FIG. 2: illustrates a power-dependent absorption rate in accordance with the present disclosure;
- FIG. 3: illustrates splitting up the microwave signal into a plurality of partial microwave signals on respective waveguides in accordance with the present disclosure;
- FIG. 4: illustrates a first mode of operation in accordance with the present disclosure of the frequency-dependent microwave filter;
- FIG. 5: illustrates a second mode of operation in accordance with the present disclosure of the frequency-dependent microwave filter;
- FIG. 6: illustrates an arrangement in accordance with the present disclosure comprising a frequency-dependent microwave filter; and
- FIG. 7: illustrates a flow diagram of a method in accordance with the present disclosure of frequency-dependent microwave filtering.

### Detailed Descriptions of Drawings

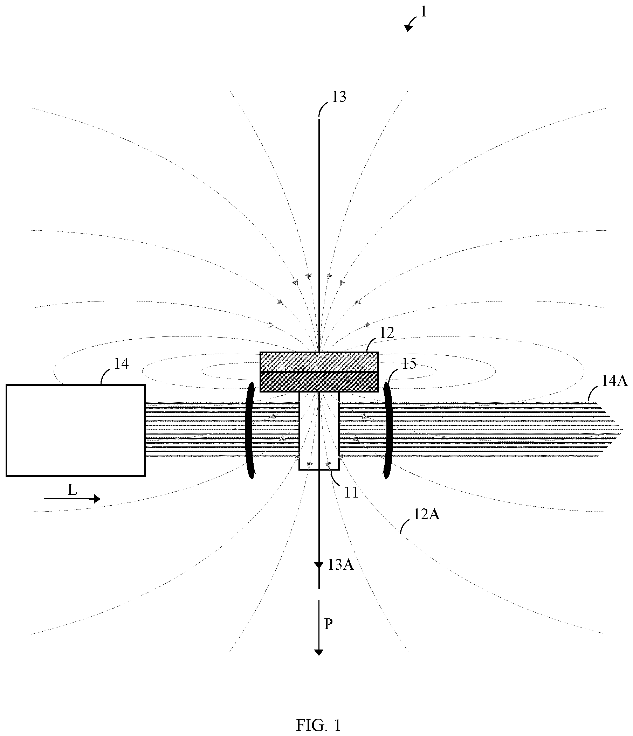

FIG. 1 illustrates a frequency-dependent microwave filter 1 in accordance with the present disclosure.

The filter 1 comprises an enclosure 11. The enclosure 11 comprises a filter medium including at least one constituent of: atoms, molecules, ions, and point defects in an optically pumpable solid, such as nitrogen-vacancy (NV) center point defects. The at least one constituent is excitable to an initial energy (i.e., ground) state. In particular, the enclosure 11 may comprise at least one of: a gas cell, and a diamond.

The gas may comprise at least one chemical element. Preferably, the at least one chemical element is from a first main group (i.e., is a group 1 element). In particular, the at least one chemical element may comprise rubidium (Rb), and may further comprise at least one of nitrogen (N₂), neon (Ne), and radon (Rn).

The filter 1 further comprises a field generator 12. The field generator 12 is configured to generate an inhomogeneous electric and/or magnetic field 12A within the enclosure 11.

In particular, the field generator 12 may comprise a permanent magnet or electromagnet configured to generate the inhomogeneous magnetic field 12A. Alternatively, the field generator 12 may comprise an arrangement configured to generate the inhomogeneous electric field 12A, such as an electrical capacitor.

The filter 1 further comprises means 13 for feedthrough of a microwave signal 13A through the enclosure 11. In particular, the means 13 for feedthrough may comprise a waveguide. The waveguide may preferably comprise a wire. The microwave signal may refer to an electromagnetic field forming and extending in an "antenna region" around said wire.

The filter 1 further comprises an optical pump 14 configured to periodically excite the at least one constituent of the filter medium to the initial energy state using a laser beam 14A in alternation with the feedthrough of the microwave signal through the enclosure 11.

Optical pumping may refer to a process of stimulating quantum systems having at least two energy levels/states, such as atoms, molecules, ions and/or point defects in an optically pumpable solid, through resonant absorption of photons of adequate frequency.

The optical pump 14 may comprise a coherent light source being resonant to at least one energy transition in the at least one constituent of the filter medium, such as a laser or a frequency comb.

A laser may refer to a device configured to emit light based on stimulated emission of electromagnetic radiation.

A frequency comb may refer to a laser source whose spectrum includes of a series of discrete, equally spaced frequency lines.

The optical pump 14 may preferably be configured to excite the filter medium in a continuous wave, (CW) mode or in a pulsed mode.

The optical pump 14 may preferably be configured to excite the filter medium from a lateral direction L which is substantially perpendicular to a propagation direction P of the microwave signal 13A, as shown in FIG. 1.

The filter 1 may further comprise an optical cavity 15 comprising the enclosure 11.

FIG. 2 illustrates a power-dependent absorption rate in accordance with the present disclosure.

As can be seen, a respective absorption rate of frequency components of the microwave signal increases with a respective energy of its frequency components.

As such, for a given duration Δt of the RF / microwave radiation, high-energy frequency components achieve a more exhaustive population inversion of the gas particles or point defects from the ground state to the excited state than low-energy frequency components, resulting in an intensity-dependent filtering of the microwave radiation in a particular interaction region of the enclosure 11.

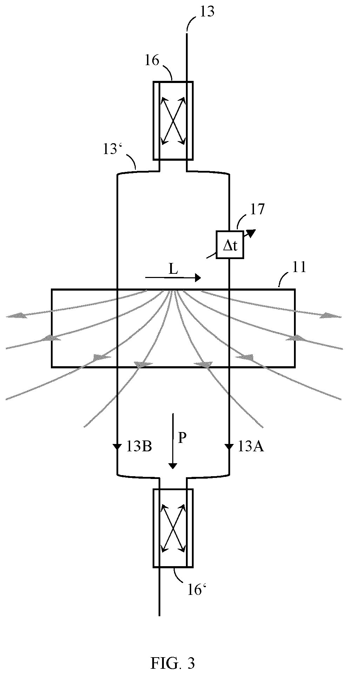

FIG. 3 illustrates splitting up the microwave signal into a plurality of partial microwave signals 13A, 13B on respective waveguides 13, 13' in accordance with the present disclosure.

To this end, the filter 1 may further comprise a power splitter or power switch 16. The power splitter or power switch 16 is configured to split up the microwave signal into a plurality of partial microwave signals 13A, 13B on respective waveguides 13, 13'. Without limitation, the exemplary 3dB power splitter 16 of FIG. 3 is configured to split up the microwave signal into two partial microwave signals 13A, 13B.

The respective waveguides 13, 13' are configured to guide the plurality of partial microwave signals 13A, 13B through the filter medium within the enclosure 11 at respective lateral positions L relative to a propagation direction P of the plurality of partial microwave signals 13A, 13B.

The filter 1 may further comprise a number of phase shifters 17 interposed in the respective waveguides 13, 13'. Without limitation, the single exemplary phase shifter 17 of FIG. 3 interposed in waveguide 13 downstream of the power splitter 16 is configured to shift a relative phase of the plurality of partial microwave signals 13A, 13B in accordance with (i.e. in relation to) a Rabi frequency f_{Rabi} of the periodic excitation of the comprised filter medium. That is to say, despite the periodic excitation of the comprised filter medium a continuous operation of the filter may be achieved in at least one portion of the filter at any time, while the gas particles or point defects in other portions of the filter revert to a ground state in accordance with the Rabi cycle.

The filter 1 may further comprise a power splitter or power switch 16' to re-combine the filtered plurality of partial microwave signals 13A, 13B.

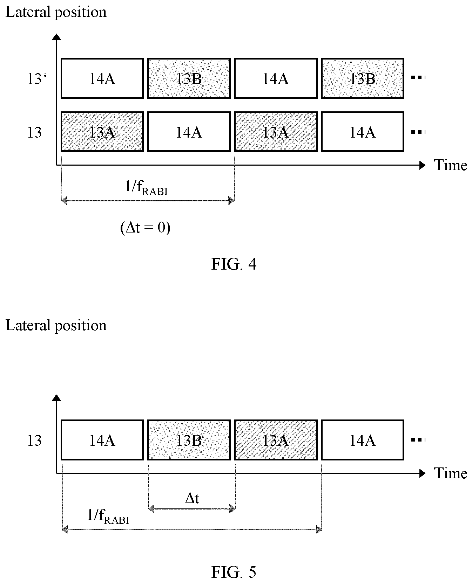

FIG. 4 illustrates a first mode of operation in accordance with the present disclosure of the frequency-dependent microwave filter 1.

The filter 1 corresponds to the exemplary implementation of FIG. 3, wherein two partial microwave signals 13A, 13B are guided through the filter medium within the enclosure 11 at respective lateral positions L corresponding to respective waveguides 13, 13'.

The two partial microwave signals 13A, 13B are not phase shifted with respect to one another (Δt = 0) and therefore represent different time intervals of the incident microwave signal.

The at least one constituent of the filter medium is periodically excited / initialized to the initial energy (i.e., ground) state at *respective* lateral positions corresponding to the waveguides 13, 13' using the laser beam 14A in accordance with the Rabi frequency f_{Rabi}. A feedthrough of the respective microwave signal 13A, 13B through the enclosure 11 takes place in alternation with said periodic optical pumping, in support of a continuous operation wherein one of the respective microwave signals 13A, 13B at a time undergoes filtering despite the periodic initialization.

FIG. 5 illustrates a second mode of operation in accordance with the present disclosure of the frequency-dependent microwave filter 1.

In this implementation, the filter 1 comprises a power splitter 16 configured to split up the microwave signal into a plurality of partial microwave signals 13A, 13B on respective waveguides 13, 13', a number of phase shifters 17 interposed in the respective waveguides 13, 13', and a power splitter 16' to re-combine the *phase-shifted* plurality of partial microwave signals 13A, 13B. The re-combined microwave signal is then passed on towards the enclosure 11 using waveguide 13.

The at least one constituent of the filter medium is periodically excited / initialized to the initial energy state using the laser beam 14A in accordance with the Rabi frequency f_{Rabi}.

As the two partial microwave signals 13A, 13B are phase shifted with respect to one another (Δt > 0), the same portion of the incident microwave signal is used multiple times to excite the at least one constituent of the filter medium from the ground state to the excited state, resulting in a different filter response.

A feedthrough of the re-combined microwave signal through the enclosure 11 takes place in alternation with said periodic optical pumping, in support of a *discontinuous* operation. A plurality of branches carrying respective re-combined microwave signals may be needed for a continuous operation.

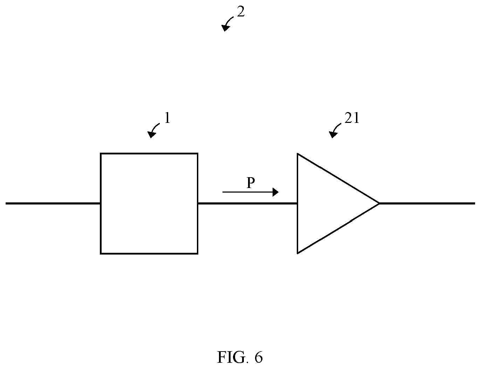

FIG. 6 illustrates an arrangement 2 in accordance with the present disclosure.

The arrangement 2 comprises a microwave amplifier 21 and a frequency-dependent microwave filter 1 of the first aspect or any of its implementations as previously described, arranged upstream (with respect to the propagation direction P of the microwave signal) of the microwave amplifier 21.

In said arrangement the frequency-dependent microwave filter 1 is configured to operate as a power limiter for the microwave amplifier 21 as well as subsequent receiver components arranged downstream of the microwave amplifier 21.

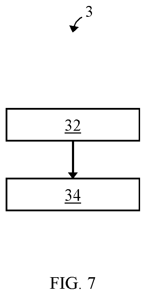

FIG. 7 illustrates a flow diagram of a method 3 in accordance with the present disclosure of frequency-dependent microwave filtering.

The method 3 comprises generating 32 an inhomogeneous electric and/or magnetic field 12A within an enclosure 11. The enclosure 11 comprises a filter medium including at least one constituent of: atoms, molecules, ions, and point defects in an optically pumpable solid. The at least one constituent is excitable to an initial energy state.

The method 3 further comprises periodically exciting 34 the at least one constituent of the filter medium to the initial energy state in alternation with a feedthrough of the microwave signal through the enclosure 11.

The method 3 may be performed by a frequency-dependent microwave filter 1 of the first aspect or any of its implementations as previously described.

## Claims

1. A frequency-dependent microwave filter (1), comprising
an enclosure (11) comprising a filter medium including at least one constituent of: atoms, molecules, ions, and point defects in an optically pumpable solid, the at least one constituent being excitable to an initial energy state;
a field generator (12) configured to generate an inhomogeneous electric and/or magnetic field (12A) within the enclosure (11);
means (13) for feedthrough of a microwave signal through the enclosure (11); and
an optical pump (14) configured to periodically excite the at least one constituent of the filter medium to the initial energy state in alternation with the feedthrough of the microwave signal through the enclosure (11).

2. The filter (1) of claim 1,
wherein inside the enclosure (11) there is provided at least one of: a gas cell, and a diamond.

3. The filter (1) of claim 2,
the gas comprising at least one chemical element;
the at least one chemical element preferably being from a first main group;
the at least one chemical element preferably comprising rubidium.

4. The filter (1) of claim 3,
the at least one chemical element further comprising at least one of: nitrogen, neon, and radon.

5. The filter (1) of any one of the preceding claims, further comprising an optical cavity (15) comprising the enclosure (11).

6. The filter (1) of any one of the preceding claims,
the means (13) for feedthrough comprising a waveguide;
the waveguide preferably comprising a wire.

7. The filter (1) of any one of the preceding claims, further comprising
a power splitter or power switch (16) configured to split up the microwave signal into a plurality of partial microwave signals (13A, 13B) on respective waveguides (13, 13') configured to guide the plurality of partial microwave signals (13A, 13B) through the filter medium at respective lateral positions relative to a propagation direction (P) of the plurality of partial microwave signals (13A, 13B).

8. The filter (1) of claim 7,
the filter (1) further comprising a number of phase shifters (17) interposed in the respective waveguides (13, 13') configured to shift a relative phase of the plurality of partial microwave signals (13A, 13B) in accordance with a Rabi frequency (f_{Rabi}) of the periodic excitation of the comprised filter medium.

9. The filter (1) of any one of the preceding claims,
the field generator (12) comprising a permanent magnet or electromagnet.

10. The filter (1) of any one of the preceding claims,
the optical pump (14) comprising a coherent light source being resonant to at least one energy transition in the at least one constituent of the filter medium;
the optical pump (14) preferably configured to excite the filter medium in a continuous wave, CW, mode or in a pulsed mode;
the optical pump (14) preferably configured to excite the filter medium from a lateral direction (L) perpendicular to the propagation direction (P) of the microwave signal.

11. An arrangement (2), comprising
a microwave amplifier (21); and
a filter (1) of any one of the claims 1 to 11 arranged upstream of the microwave amplifier (21).

12. A method (3) of frequency-dependent microwave filtering, comprising
generating (32) an inhomogeneous electric and/or magnetic field (12A) within an enclosure (11), the enclosure (11) comprising a filter medium including at least one constituent of: atoms, molecules, ions, and point defects in an optically pumpable solid, the at least one constituent being excitable to an initial energy state;
periodically exciting (34) the at least one constituent of the filter medium to the initial energy state in alternation with a feedthrough of the microwave signal through the enclosure (11).

13. The method (3) of claim 12,
wherein a respective absorption rate of frequency components of the microwave signal increases with a respective energy of its frequency components.

14. The method (3) of claim 12 or claim 13,
being performed by a filter (1) of any one of the claims 1 to 10.
